# FASCICULE DE BREVET EUROPEEN

(11) **EP 1 564 883 B1**
(45) Date de publication et mention de la délivrance du brevet: **20.04.2011**
(21) Numéro de dépôt: 04290333.6
(22) Date de dépôt: 10.02.2004
(51) Int. Cl.: H03D 7/14

(54) **Procédé et dispositif de transposition de fréquence, en particulier pour le contrôle de la puissance d'émission d'un téléphone mobile cellulaire**
Verfahren und Vorrichtung zur Frequenzumsetzung, inbesondere zum Einstellen der Sendeleistung in einem zellularen Mobiltelefon
Method and apparatus for frequency conversion, in particular for controlling the emitting power of a cellular mobile telephone

(43) Date de publication de la demande: 17.08.2005
(73) Titulaire: STMicroelectronics N.V., 1118 BH Schiphol Airport Amsterdam (NL)
(72) Inventeur: Smaini, Lydi, 92250 La Garenne Colombes (FR); Cerisier, Patrick, 74350 Copponex (FR); Gouessant, Philippe, 74160 COLLONGES-SOUS-SALEVE (FR)
(74) Mandataire: Zapalowicz, Francis

(56) Documents cités:
- EP-A- 0 740 422
- US-A- 5 534 827
- PATENT ABSTRACTS OF JAPAN vol. 1998, no. 12, 31 octobre 1998 (1998-10-31) -& JP 10 190509 A (NEC CORP), 21 juillet 1998 (1998-07-21)

## Description

L'invention concerne la transposition de fréquence et s'applique avantageusement mais non limitativement dans le domaine de la radiofréquence, par exemple en téléphonie mobile, dans lequel les circuits radiofréquences utilisent largement des dispositifs de transposition de fréquence, ou mélangeurs de fréquence, tant à l'émission qu'à la réception.

A l'émission, les mélangeurs de fréquence, qui sont en l'espèce des circuits élévateurs de fréquence, ont pour but de transposer l'information en bande de base autour de la porteuse émission.

US 5 534 827 décrit un modulateur d'amplitude utilisant un modulateur delta sigma. EP 0 740 422 décrit un circuit de contrôle de puissance pour un appareil de transmission comportant un mélangeur de fréquence classique.

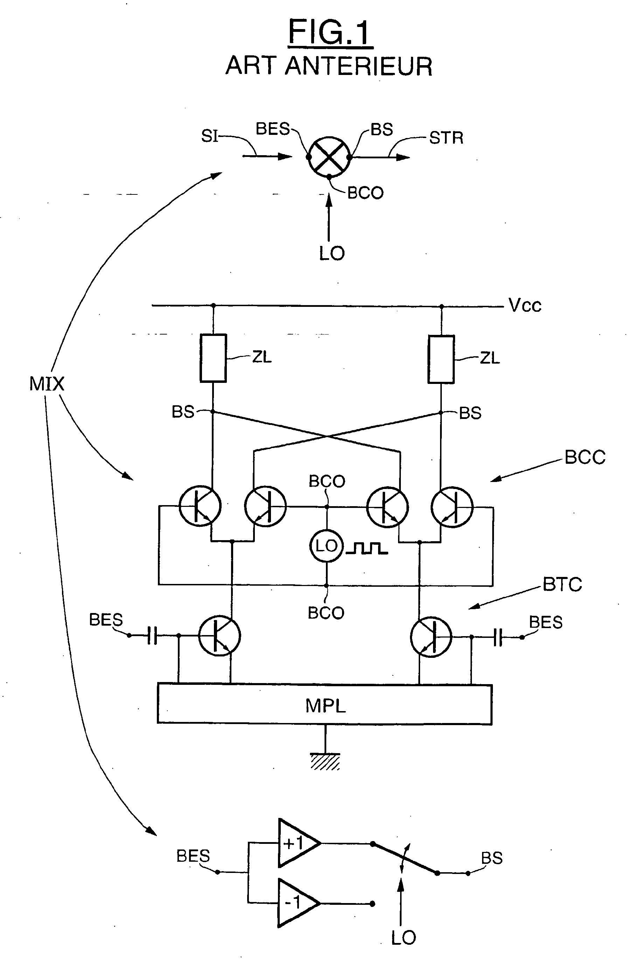

La figure 1 illustre schématiquement la structure habituellement utilisée pour les dispositifs de transposition de fréquence de l'art antérieur.

Sur la partie haute de la figure 1, la référence MIX désigne un moyen de transposition de fréquence, ou mélangeur (ici élévateur de fréquence), possédant une borne d'entrée BES pour recevoir un signal incident SI, par exemple en bande de base ou bien à une fréquence intermédiaire. Le mélangeur MIX possède également une borne de commande BCO pour recevoir un signal d'oscillateur local LO, par exemple autour de 2 GHz dans une application de téléphonie mobile utilisant des systèmes CDMA (systèmes à accès multiples par division de code : « Code Division Multiple Access», en langue anglaise), et une borne de sortie BS pour délivrer le signal de sortie STR qui est un signal transposé dont le spectre fréquentiel se situe autour de la fréquence fondamentale du signal d'oscillateur local et des harmoniques de rang impaire. L'amplitude de ces harmoniques décroît de façon proportionnelle à leur rang, c'est-à-dire qu'elle décroît, en décibels, avec une pente de -20 dB par décade.

Ainsi, en pratique, le mélangeur MIX est suivi d'un filtre passe-bande centré autour de la fréquence fondamentale de l'oscillateur local, de façon à ne conserver que la partie du spectre centrée autour de cette fréquence fondamentale.

La structure habituellement utilisée pour ces mélangeurs est une structure de type Gilbert, en général différentielle, telle qu'illustrée schématiquement sur la partie médiane de la figure 1.

Une telle cellule est bien connue de l'homme du métier et l'on en rappelle ici les caractéristiques essentielles.

Plus précisément, une telle cellule comporte un bloc transducteur différentiel BTC pour convertir le signal d'entrée (tension) présent sur les bornes BES en un courant différentiel. Ici, ce bloc BTC comporte un étage constitué d'une paire différentielle de transistors dont les bases respectives sont reliées aux bornes d'entrée par deux condensateurs. Les collecteurs des deux transistors de cet étage forment les bornes de sortie de ce bloc transducteur BTC. Bien entendu, le bloc BTC peut comporter plusieurs étages.

Les transistors de l'étage du bloc BTC sont polarisés par des moyens de polarisation classiques MPL comportant notamment des résistances ainsi qu'une source de tension.

A la sortie du bloc transducteur BTC, c'est-à-dire aux collecteurs des transistors de ce bloc BTC, est connecté un bloc de commutation de courant BCC aiguillant le courant alternativement vers l'une ou l'autre des deux bornes de sortie BS à la fréquence du signal d'oscillateur local LO reçu au niveau des bornes BCO. Ce bloc BCC comporte classiquement deux paires de transistors.

Chaque résistance ZL, connectée entre les bornes de sortie BS du bloc BCC et l'alimentation Vcc, représente la charge de sortie du mélangeur MIX.

Le bloc BTC convertit la puissance ou la tension appliquée à l'entrée BES en un courant différentiel qui est une image supposée linéaire du signal d'entrée. Ce signal linéaire est ensuite découpé par une fonction carrée non linéaire (+1, -1, +1, -1...) réalisée par le double commutateur BCC, à la fréquence du signal LO, ce double commutateur faisant office d'aiguilleur dynamique du courant. Le signal de sortie est recueilli aux bornes de la charge différentielle 2ZL.

En d'autres termes, comme illustré également schématiquement sur la partie basse de la figure 1, le signal STR présent à la borne de sortie BS du mélangeur MIX correspond au signal incident SI multiplié par +1 (c'est-à-dire non inversé) et -1 (c'est-à-dire inversé) au rythme du signal périodique d'oscillateur local LO, généralement écrêté à +1 et -1.

Ainsi, dans un tel mélangeur classique, l'entrée de commande ou encore entrée d'oscillateur local, reçoit un signal de transposition périodique (signal d'oscillateur local) ayant la fréquence de transposition désirée, et avec un niveau de puissance fixe nécessaire pour piloter les transistors du bloc de commutation BCC de la cellule de Gilbert.

Par ailleurs, la puissance du signal transposé est égale, aux pertes près, à la puissance du signal incident.

Dans ces conditions, et dans l'hypothèse où l'on dispose d'un signal incident de faible puissance qu'il convient de transmettre, après transposition, avec une puissance élevée, il est alors nécessaire d'effectuer une amplification de signal, celle-ci comportant généralement une amplification du signal incident avant transposition et une amplification après transposition.

Cependant, lorsqu'une forte amplification du signal incident est nécessaire dans certaines applications, par exemple en téléphonie mobile, celle-ci s'avère particulièrement délicate à réaliser car la linéarité du signal incident doit être préservée lors de l'amplification afin de ne pas perdre d'information lors du mélange (transposition).

L'invention vise à apporter une solution à ce problème.

Un but de l'invention est de proposer une transposition de fréquence intégrant en quelque sorte une fonction d'amplification, et ce sans affecter la linéarité du signal incident à transposer.

L'invention propose un procédé de transposition de fréquence d'un signal incident, comprenant une modulation du signal incident du type delta-sigma sur 1 bit, de façon à générer un signal binaire représentatif du signal incident, une génération d'un signal auxiliaire périodique de fréquence égale à la fréquence de transposition désirée, et des successions d'inversions et de non-inversions du signal auxiliaire, commandées par les états successifs du signal binaire, de façon à générer un signal transposé.

Ainsi, selon l'invention, l'entrée du signal habituelle d'un mélangeur reçoit ici non pas le signal incident à transposer, comme dans l'art antérieur, mais un signal auxiliaire, ou signal de porteuse, périodique et de fréquence égale à la fréquence de transposition désirée (ce signal est donc le signal de transposition), tandis que l'entrée de commande habituelle d'un mélangeur ne reçoit pas le signal de transposition (signal d'oscillateur local) comme c'est le cas dans l'art antérieur, mais un signal binaire (c'est-à-dire codé sur deux états, +1 et -1, par exemple) issu d'une modulation du type delta-sigma à 1 bit du signal incident.

Et, la puissance du signal de sortie dépend alors de la puissance du signal incident, mais également de l'amplitude du signal auxiliaire.

Par ailleurs, la question de la linéarité des signaux en cas de forte puissance n'est plus critique ici selon l'invention, car il n'y a pas de perte d'information du signal incident. En effet, le signal à la sortie du modulateur delta-sigma, bien qu'il ait une amplitude constante, contient toute l'information du signal d'entrée (amplitude et phase) codée sur l'axe des temps. Ainsi, le modulateur delta-sigma permet de coder le signal avec 1 bit tout en rejetant le bruit de quantification en-dehors de la bande utile du signal.

Il est par ailleurs particulièrement avantageux que l'amplitude du signal auxiliaire soit variable, ce qui permet alors un ajustement de cette amplitude en fonction de la puissance désirée pour le signal transposé.

L'invention propose également un dispositif de transposition de fréquence comprenant
- une borne d'entrée pour recevoir un signal incident,
- un modulateur du type delta-sigma à un bit connecté à ladite borne d'entrée,
- des moyens de génération d'un signal auxiliaire périodique de fréquence égale à la fréquence de transposition désirée, et
- des moyens de transposition de fréquence du type cellule de Gilbert possédant une entrée de signal connectée à la sortie des moyens de génération, une entrée de commande connectée à la sortie du modulateur delta-sigma, et une sortie délivrant un signal transposé.

Selon un mode de réalisation de l'invention, l'amplitude du signal auxiliaire est variable et le dispositif comprend alors en outre des moyens de réglage de cette amplitude en fonction d'une puissance désirée pour le signal transposé.

Le signal incident peut être un signal analogique ou numérique.

L'invention propose également un composant d'un système de communication sans fil, par exemple un téléphone mobile cellulaire, comprenant une voie d'émission comportant un étage de traitement numérique délivrant deux signaux numériques en bande de base en quadrature, et un étage amplificateur de sortie. La voie d'émission comporte alors au moins un dispositif de transposition de fréquence tel que défini ci-avant, disposé entre l'étage de traitement numérique et l'étage amplificateur de sortie.

D'autres avantages et caractéristiques de l'invention apparaîtront à l'examen de la description détaillée de mode de réalisation et de mise en oeuvre, nullement limitatif, et des dessins annexés, sur lesquels :
- la figure 1, déjà décrite, illustre un moyen de transposition selon l'art antérieur ;
- les figures 2 et 3 illustrent très schématiquement un dispositif de transposition de fréquence selon l'invention ;
- la figure 4 illustre schématiquement un modulateur delta-sigma à 1 bit incorporé dans un dispositif de transposition de fréquence selon l'invention ;
- la figure 5 illustre schématiquement la structure d'un téléphone mobile cellulaire selon l'invention, incorporant dans sa voie d'émission au moins un dispositif de transposition de fréquence selon l'invention ;
- la figure 6 illustre plus en détail un mode de réalisation de la voie d'émission d'un téléphone mobile cellulaire selon l'invention ; et
- la figure 7 illustre schématiquement un autre mode de réalisation d'une voie d'émission d'un téléphone mobile cellulaire selon l'invention.

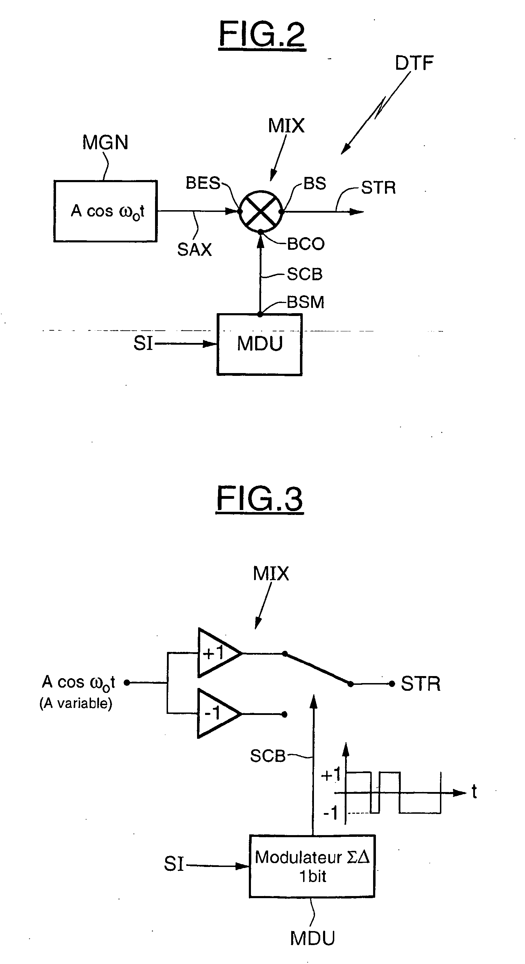

Sur la figure 2, la référence DTF désigne un dispositif de transposition de fréquence comportant un moyen de transposition de fréquence ou mélangeur MIX, du type cellule de Gilbert. Ainsi, le mélangeur MIX de la figure 2 peut être identique structurellement au mélangeur MIX de la partie médiane de la figure 1.

Ce mélangeur MIX comporte ainsi une entrée de signal BES, une entrée de commande BCO et une sortie BS délivrant un signal transposé STR.

Le dispositif de transposition de fréquence DTF comporte également des moyens de génération MGN aptes à générer un signal auxiliaire SAX. Ce signal auxiliaire ou signal de porteuse, est un signal périodique ayant une fréquence égale à la fréquence de transposition désirée. Dans le cas présent, ce signal auxiliaire est un signal de la forme Acos2πcf₀t, où f₀ désigne la fréquence de transposition (ω₀ = 2πf₀).

L'amplitude A du signal auxiliaire SAX est avantageusement ajustable et son ajustement va permettre de faire varier la puissance du signal de sortie, c'est-à-dire la puissance du signal transposé STR.

De tels moyens de génération sont de structure classique et connue en soi.

Un autre élément essentiel de l'invention réside dans un modulateur de type delta-sigma, référencé MDU, recevant en entrée le signal incident à transposer SI et délivrant en sortie sur sa borne BSM un signal binaire, c'est-à-dire à deux états, par exemple +1 et -1, représentatif du signal incident SI. En d'autres termes, de par la modulation delta-sigma sur 1 bit, le signal SCB délivré en sortie du modulateur MDU a une amplitude constante et contient toute l'information du signal d'entrée SI, tant en amplitude qu'en phase, cette information étant codée sur l'axe du temps. Par ailleurs, le modulateur delta-sigma permet non seulement de coder le signal SI sur 1 bit, mais également de rejeter le bruit de quantification en-dehors de la bande utile du signal incident SI.

Bien que le mélangeur MIX soit par exemple structurellement identique à un mélangeur de l'art antérieur, la nature des signaux qu'il reçoit sur ses deux entrées, à savoir l'entrée de signal d'une part, et l'entrée de commande d'autre part, est totalement différente et inhabituelle par rapport au mélangeur de l'art antérieur.

Plus précisément, alors que l'entrée de signal d'un mélangeur reçoit dans l'art antérieur le signal à transposer, l'entrée de signal BES du mélangeur MIX selon l'invention reçoit ici le signal auxiliaire, c'est-à-dire le signal de porteuse, qui va définir la fréquence de transposition.

Par ailleurs, alors que dans l'art antérieur l'entrée de commande reçoit le signal de transposition, le mélangeur MIX selon l'invention reçoit sur son entrée de commande BCO le signal codé binaire SCB issu du signal à transposer après modulation de type delta-sigma sur 1 bit.

Le signal STR, qui est le signal transposé délivré sur la borne de sortie BS du mélangeur MIX, contient le spectre du signal incident SI transposé autour de la fréquence de transposition F₀.

De plus, la puissance de sortie du signal STR dépend à la fois de la puissance du signal incident SI, mais également de l'amplitude A du signal auxiliaire SAX. Ainsi, il est possible de piloter la puissance du signal STR en agissant sur l'amplitude A du signal de porteuse SAX.

Sur la figure 3, qui illustre une autre représentation schématique du mélangeur MIX selon l'invention, on voit donc que l'on effectue des successions d'inversions et de non-inversions du signal auxiliaire SAX (c'est-à-dire des successions de multiplications par +1 et par -1), ces successions d'inversions et de non-inversions étant commandées par les états successifs du signal binaire SCB. Ainsi, par exemple, à chaque fois que l'on a un état +1 pour le signal SCB, on effectuera une non-inversion du signal SAX, tandis que l'on inversera le signal SAX lors d'un état -1 du signal SCB.

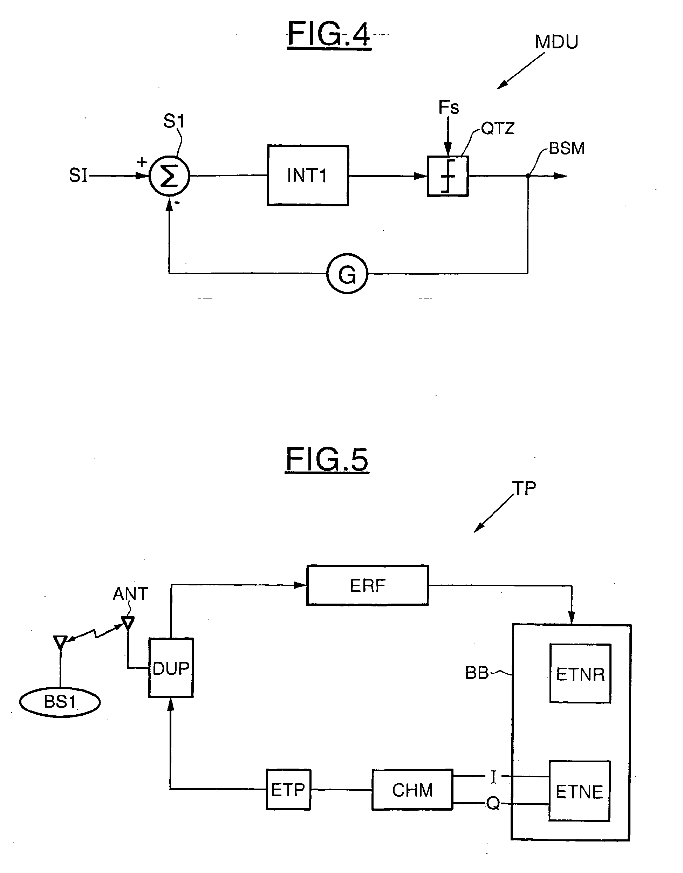

La structure d'un modulateur de type delta-sigma est classique et bien connue par l'homme du métier. On en rappelle ici brièvement les principales caractéristiques, en se référant plus particulièrement à la figure 4.

Le modulateur MDU comporte en tête un sommateur S1 (soustracteur) recevant le signal incident SI. Ce soustracteur est suivi ici d'un opérateur INT1 dont la sortie est reliée à l'entrée d'un moyen de quantification QTZ (échantillonneur) dont la sortie constitue la sortie du modulateur MDU. La sortie du moyen de quantification QTZ est rebouclée sur l'entrée négative du sommateur S1 par l'intermédiaire d'un gain G.

La modulation « delta » est basée sur la quantification de la modification du signal d'échantillon à échantillon, plutôt que sur la quantification de la valeur absolue du signal à chaque échantillon.

La présence d'un intégrateur (sigma) dans le modulateur confère au modulateur la dénomination de modulateur « delta-sigma ».

La sortie du modulateur delta-sigma est à une fréquence de suréchantillonnage Fs très élevée. C'est une caractéristique fondamentale des modulateurs delta-sigma parce qu'ils utilisent la portion haute fréquence du spectre pour repousser la majeur partie du bruit de quantification.

En effet, on rappelle qu'un modulateur delta-sigma est conçu pour repousser le bruit de quantification hors de la bande du signal utile.

Le modulateur delta-sigma MDU décrit ici est un modulateur d'ordre 1, car il ne comporte qu'un seul soustracteur et un seul intégrateur. Cela étant, on pourra utiliser un modulateur delta-sigma d'ordre supérieur. Par ailleurs, puisque la modulation s'effectue sur un bit, le moyen de quantification est ici un simple comparateur qui délivre deux niveaux, +1 ou -1, par exemple.

Enfin, en raison de la présence d'un intégrateur, le modulateur delta-sigma est ici un modulateur delta-sigma passe-bas. Cela étant, l'invention est également compatible avec des modulateurs delta-sigma passe-bande qui comportent, à la place d'un intégrateur, un filtre passe-bande. Ces modulateurs, bien qu'ils ne possèdent pas d'intégrateur (sigma), gardent toujours par abus de langage la dénomination « modulateur delta-sigma ».

On va maintenant décrire, en se référant plus particulièrement aux figures 5 et suivantes, un exemple d'application d'une telle transposition de fréquence à un système de téléphonie mobile.

Sur la figure 5, la référence TP désigne un terminal distant, tel qu'un téléphone mobile cellulaire, qui est en communication avec une station de base BS1, par exemple selon un schéma de communication du type CDMA.

Le téléphone mobile cellulaire comprend, de façon classique, un étage analogique radiofréquence ERF connecté à un antenne ANT par l'intermédiaire d'un duplexeur DUP, pour recevoir un signal d'entrée.

Classiquement, l'étage ERF comprend un amplificateur faible bruit et deux voies de traitement comportant des mélangeurs, des filtres et amplificateurs classiques. Les deux mélangeurs reçoivent respectivement de la part d'une boucle à verrouillage de phase deux signaux présentant mutuellement une différence de phase de 90°. Après transposition de fréquence dans les mélangeurs, les deux voies de traitement définissent respectivement deux flux I (flux direct) et Q (flux en quadrature) selon une dénomination bien connue de l'homme du métier.

Après conversion numérique dans des convertisseurs analogiques/numériques, les deux flux I et Q sont délivrés à un étage de traitement de réception ETNR qui fait partie d'un module numérique de traitement en bande de base BB.

Cet étage de traitement ETNR comprend, de façon classique, un récepteur communément désigné par l'homme du métier « récepteur Rake », suivi par des moyens classiques de démodulation qui effectuent la démodulation de la constellation délivrée par le récepteur Rake.

Le bloc de traitement en bande de base BB comporte, outre les plages de traitement ETNR, un étage de traitement d'émission ETNE qui effectue, de façon classique, notamment les traitements de codage de source, d'étalement des symboles, de modulation, pour délivrer les deux flux I et Q en bande de base à un bloc analogique d'émission CHM de structure classique. Le bloc CHM est classiquement suivi d'un étage d'amplificateur de puissance ETP connecté à l'antenne par le duplexeur DUP.

Dans les systèmes CDMA, et en particulier les systèmes WCDMA, dans lesquels l'émission et la réception se font simultanément, il faut contrôler la puissance du signal émis sur une large plage, typiquement environ +80 dB, la puissance du signal devant varier de -50 dBm à +24 dBm.

Actuellement, ce contrôle de puissance nécessite l'utilisation de plusieurs étages amplificateurs, en général variables, ce qui est en général complexe à réaliser, notamment du point de vue de la linéarité de l'amplification.

L'utilisation dans la voie d'émission d'un téléphone mobile cellulaire, d'au moins un dispositif de transposition de fréquence selon l'invention, permet de résoudre ce problème.

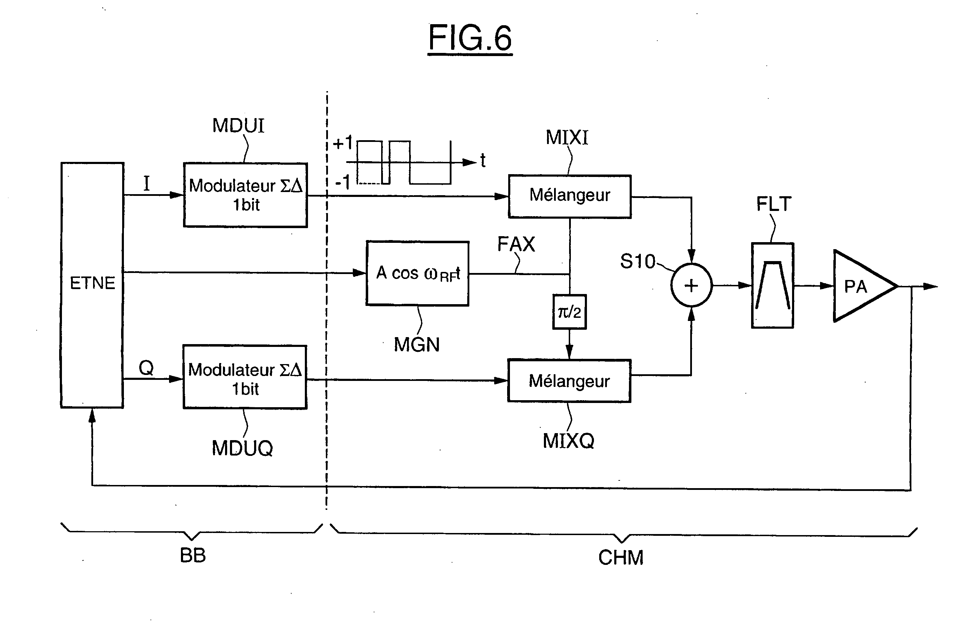

Plus précisément, sur la figure 6, un modulateur delta-sigma passe-bas à un bit, référencé MDUI, est connecté au sein du bloc de traitement en bande de base BB, à la sortie de l'étage de traitement numérique ETNE sur la voie I.

De même, un modulateur analogue MDUQ est connecté en sortie de l'étage ETNE sur la voie Q.

Ces deux modulateurs delta-sigma sont des modulateurs numériques, c'est-à-dire que la fonction intégration ainsi que les fonctions de sommation sont réalisées en numérique.

Les deux signaux en bande de base I et Q subissent donc une modulation delta-sigma sur un bit et, après conversion numérique analogique, ils sont délivrés respectivement sur les entrées de commande des deux mélangeurs MXI et MXQ.

Par ailleurs, les moyens de génération du signal auxiliaire MGN délivrent un signal auxiliaire ou signal de porteuse du type cosinusoïdal, à une fréquence de transposition radiofréquence F_{RF}.

Le signal auxiliaire SAX est alors délivré sur l'entrée de signal du mélangeur MIXI, ainsi que sur l'entrée de signal du mélangeur MIXQ, après un déphasage de π/2.

Les deux signaux transposés à la fréquence de transposition, respectivement issus des mélangeurs MIXI et MIXQ, sont sommés dans un sommateur S10, puis le signal résultant est filtré dans un filtre passe-bande FLT centré autour de la fréquence de transposition F_{RF}. Le signal filtré est ensuite délivré à un amplificateur de sortie PA de l'étage d'amplification ETP.

Une information relative à la puissance du signal d'émission en sortie de l'amplificateur PA, est renvoyée vers l'étage de traitement numérique ETNE et le processeur incorporé dans cet étage peut alors, en fonction de cette information, ajuster l'amplitude A du signal auxiliaire SAX, de façon à contrôler la puissance du signal en sortie des mélangeurs, et par conséquent la puissance du signal d'émission.

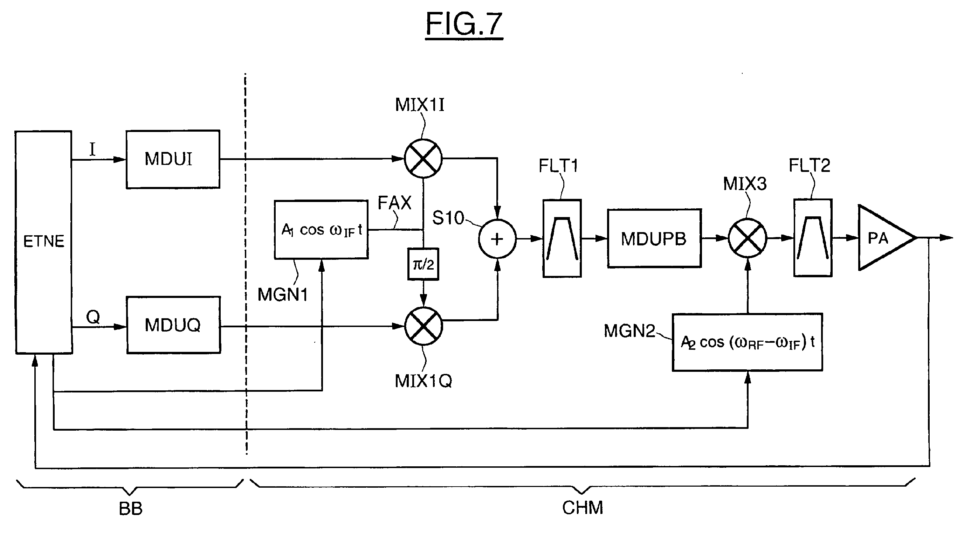

Dans l'exemple d'architecture d'émetteur de la figure 6, les signaux I et Q issus de l'étage de traitement numérique en bande de base sont codés par des modulateurs delta-sigma passe-bas 1 bit avant d'être appliqués aux deux mélangeurs en quadrature pour les transposer à la fréquence d'émission. Cela étant, on peut également envisager un exemple d'architecture tel que celui illustré sur la figure 7, dans lequel on passe d'abord par une fréquence intermédiaire, qui peut être réalisée de façon numérique ou analogique, combinée avec l'utilisation d'un modulateur delta-sigma 1 bit passe-bande.

Plus précisément, comme illustré sur la figure 7, les signaux I et Q, issus de l'étage ETNE, subissent une modulation delta-sigma dans des modulateurs delta-sigma passe-bas 1 bit MDUI et MDUQ, avant d'être transposés, dans deux mélangeurs MX1I et MX1Q, à une fréquence intermédiaire F_{IF}, en utilisant un signal de porteuse cosinusoïdal généré par des premiers moyens de génération MGN1.

Les deux signaux transposés ainsi obtenus sont sommés dans un sommateur S10, puis le signal sommé est filtré dans un premier filtre passe-bande FLT1 centré autour de la fréquence intermédiaire F_{IF}.

Le signal filtré subit alors une modulation delta-sigma 1 bit dans un modulateur MDUPB qui est un modulateur delta-sigma 1 bit passe-bande.

Le signal modulé est appliqué sur l'entrée de commande d'un mélangeur MIX3, qui va transposer le signal à la fréquence d'émission radiofréquence F_{RF} en utilisant un signal de porteuse cosinusoïdal ayant une fréquence F_{RF}-F_{IF}, appliqué sur l'entrée de signal du mélangeur MIX3.

La sortie du signal transposé est filtrée dans un deuxième filtre passe-bande FLT2 centré autour de la fréquence d'émission radiofréquence F_{RF}, avant d'être amplifié par l'amplificateur de sortie PA.

Là encore, la puissance d'émission du signal de sortie est transmise à l'étage de traitement numérique ETNE, de façon que le processeur en bande de base puisse agir éventuellement sur les moyens de génération MGN1 et MGN2, de façon à ajuster l'amplitude A1 du premier signal de porteuse et/ou l'amplitude A2 du deuxième signal de porteuse.

## Revendications

1. Procédé de transposition de fréquence d'un signal incident, comprenant une modulation (MDU) du signal incident du type delta-sigma sur un bit de façon à générer un signal binaire (SCB) représentatif du signal incident, une génération (MGN) d'un signal auxiliaire périodique (SAX) de fréquence égale à la fréquence de transposition désirée, et une transposition de fréquence effectuée dans des moyens de transposition de fréquence (MIX) du type cellule de Gilbert et comportant des successions d'inversions et de non-inversions du signal auxiliaire (SAX) délivré sur l'entrée de signal des moyens de transposition de fréquence (MIX) commandées par les états successifs du signal binaire (SCB) délivré sur l'entrée de commande des moyens de transposition de fréquence (MIX) de façon à générer un signal transposé (STR).

2. Procédé selon la revendication 1, **caractérisé par le fait que** l'amplitude (A) du signal auxiliaire (SAX) est variable et **par le fait que** le procédé comprend en outre un ajustement de cette amplitude (A) en fonction d'une puissance désirée pour le signal transposé (STR).

3. Dispositif de transposition de fréquence, **caractérisé par le fait qu'**il comprend
- une borne d'entrée pour recevoir un signal incident (SI).
- un modulateur du type delta-sigma à un bit (MDU) connecté à ladite borne d'entrée,
- des moyens de génération (MGN) d'un signal auxiliaire (SAX) périodique de fréquence égale à la fréquence de transposition désirée, et
- des moyens de transposition de fréquence (MIX) du type cellule de Gilbert possédant une entrée de signal (BES) connectée à la sortie des moyens de génération (MGN), une entrée de commande (BCO) connectée à la sortie du modulateur delta-sigma (MDU), et une sortie (BS) délivrant un signal transposé (STR).

4. Dispositif selon la revendication 3, **caractérisé par le fait que** l'amplitude (A) du signal auxiliaire (SAX) est variable et **par le fait que** le dispositif comprend en outre des moyens de réglage (ETNE) de cette amplitude en fonction d'une puissance désirée pour le signal transposé.

5. Dispositif selon la revendication 3 ou 4, **caractérisé par le fait que** le signal incident (SI) est un signal analogique ou numérique.

6. Composant d'un système de communication sans fil, comprenant une voie d'émission comportant un étage de traitement numérique (ETNE) délivrant deux signaux numériques en bande de base en quadrature (I, Q), et un étage amplificateur de sortie (ETP), **caractérisé par le fait que** la voie d'émission comporte au moins un dispositif de transposition de fréquence (MIXI, MIXQ) selon l'une des revendications 3 à 5, disposé entre l'étage de traitement numérique (ETNE) et l'étage amplificateur de sortie (ETP).

7. Composant selon la revendication 6, **caractérisé par le fait qu'**il forme un téléphone mobile cellulaire (TP).

## Claims

1. Method for the frequency transposition of an incident signal, comprising a modulation (MDU) of the incident signal of the delta-sigma type over one bit so as to generate a binary signal (SCB) that is representative of the incident signal, a generation (MGN) of a periodic auxiliary signal (SAX) with a frequency equal to the desired transposition frequency, and a frequency transposition carried out in frequency transposition means (MIX) of the Gilbert cell type and having successions of inversions and non-inversions of the auxiliary signal (SAX) delivered at the signal input of the frequency transposition means (MIX) controlled by the successive states of the binary signal (SCB) delivered at the control input of the frequency transposition means (MIX) so as to generate a transposed signal (STR).

2. Method according to Claim 1, **characterized in that** the amplitude (A) of the auxiliary signal (SAX) is variable and **in that** the method also comprises an adjustment of this amplitude (A) depending on the desired power for the transposed signal (STR).

3. Frequency transposition device, **characterized in that** it comprises
- an input terminal for receiving an incident signal (SI),
- a modulator of the one-bit delta-sigma type (MDU) connected to the said input terminal,
- means (MGN) for generating a periodic auxiliary signal (SAX) with a frequency equal to the desired transposition frequency, and
- frequency transposition means (MIX) of the Gilbert cell type having a signal input (BES) connected to the output of the generation means (MGN), a control input (BCO) connected to the output of the delta-sigma modulator (MDU), and an output (BS) delivering a transposed signal (STR).

4. Device according to Claim 3, **characterized in that** the amplitude (A) of the auxiliary signal (SAX) is variable and **in that** the device also comprises means (ETNE) for adjusting this amplitude depending on a desired power for the transposed signal.

5. Device according to either of Claims 3 and 4, **characterized in that** the incident signal (SI) is an analogue or digital signal.

6. Component of a wireless communication system, comprising a transmission channel comprising a digital processing stage (ETNE) delivering two baseband digital signals (I, Q) in quadrature, and an output amplifier stage (ETP), **characterized in that** the transmission channel comprises at least one frequency transposition device (MIXI, MIXQ), according to one of Claims 3 to 5, disposed between the digital processing stage (ETNE) and the output amplifier stage (ETP).

7. Component according to Claim 6, **characterized in that** it forms a cellular mobile telephone (TP).

## Patentansprüche

1. Verfahren zur Frequenzumsetzung eines ankommenden Signals, das eine Modulation (MDU) des ankommenden Signals des Delta-Sigma-Typs an einem Bit, derart, dass ein das ankommende Signal repräsentierendes binäres Signal (SCB) erzeugt wird, eine Erzeugung (MGN) eines periodischen Hilfssignals (SAX) mit einer Frequenz, die gleich der gewünschten Umsetzungsfrequenz ist, und eine Frequenzumsetzung, die in Frequenzumsetzungsmitteln (MIX) des Gilbert-Zellen-Typs ausgeführt wird und eine Folge von Umkehrungen und Nichtumkehrungen des Hilfssignals (SAX) enthält, das an den Signaleingang der Frequenzumsetzungsmittel (MIX) geliefert wird, die durch die aufeinander folgenden Zustände des binären Signals (SCB) gesteuert werden, das an den Steuereingang der Frequenzumsetzungsmittel (MIX) geliefert wird, um ein umgesetztes Signal (STR) zu erzeugen, enthält.

2. Verfahren nach Anspruch 1, **dadurch gekennzeichnet, dass** die Amplitude (A) des Hilfssignals (SAX) variabel ist und dass das Verfahren außerdem eine Einstellung dieser Amplitude (A) als Funktion einer für das umgesetzte Signal (STR) gewünschten Leistung enthält.

3. Vorrichtung zur Frequenzumsetzung, **dadurch gekennzeichnet, dass** sie enthält:
- einen Eingangsanschluss, um ein ankommendes Signal (SI) zu empfangen,
- einen Modulator des Delta-Sigma-Typs mit einem Bit (MDU), der mit dem Eingangsanschluss verbunden ist,
- Mittel (MGN), um ein periodisches Hilfssignal (SAX) mit einer Frequenz, die gleich der gewünschten Umsetzungsfrequenz ist, zu erzeugen, und
- Mittel (MIX) zur Frequenzumsetzung des Gilbert-Zellen-Typs, die einen Signaleingang (BES), der mit dem Ausgang der Erzeugungsmittel (MGN) verbunden ist, einen Steuereingang (BCO), der mit dem Ausgang des Delta-Sigma-Modulators (MDU) verbunden ist, und einen Ausgang (BS), der ein umgesetztes Signal (STR) liefert, enthalten.

4. Vorrichtung nach Anspruch 3, **dadurch gekennzeichnet, dass** die Amplitude (A) des Hilfssignals (SAX) veränderlich ist und dass die Vorrichtung außerdem Mittel (ETNE) zum Regulieren dieser Amplitude als Funktion einer für das umgesetzte Signal gewünschten Leistung enthält.

5. Vorrichtung nach Anspruch 3 oder 4, **dadurch gekennzeichnet, dass** das ankommende Signal (SI) ein analoges oder digitales Signal ist.

6. Komponente eines Systems zur drahtlosen Kommunikation, mit einem Sendekanal, der eine digitale Verarbeitungsstufe (ETNE), die zwei digitale Quadratur-Grundbandsignale (I, Q) liefert, und eine Ausgangsverstärkerstufe (ETP) enthält, **dadurch gekennzeichnet, dass** der Sendeweg wenigstens eine Frequenzumsetzungsvorrichtung (MIXI, MIXQ) nach einem der Ansprüche 3 bis 5 enthält, die zwischen der digitalen Verarbeitungsstufe (ETNE) und der Ausgangsverstärkerstufe (ETP) angeordnet ist.

7. Komponente nach Anspruch 6, **dadurch gekennzeichnet, dass** sie ein Zellenmobiltelephon (TP) bildet.
